(19) Europäisches Patentamt
European Patent Office
Office européen des brevets

(11) EP 1 559 740 A1

(12) EUROPÄISCHE PATENTANMELDUNG

(43) Veröffentlichungstag:
**03.08.2005 Patentblatt 2005/31**

(51) Int Cl.⁷: **C08J 5/18**, C08L 67/02, C08K 3/00, C08K 3/22, C23C 18/16, H05K 3/18

(21) Anmeldenummer: **05000974.5**

(22) Anmeldetag: **19.01.2005**

(84) Benannte Vertragsstaaten:
**AT BE BG CH CY CZ DE DK EE ES FI FR GB GR HU IE IS IT LI LT LU MC NL PL PT RO SE SI SK TR**
Benannte Erstreckungsstaaten:
**AL BA HR LV MK YU**

(30) Priorität: **27.01.2004 DE 102004003891**

(71) Anmelder: **Mitsubishi Polyester Film GmbH
65203 Wiesbaden (DE)**

(72) Erfinder:
- **Kliesch, Holger, Dr.
65462 Ginsheim-Gustavsburg (DE)**
- **Kiehne, Thorsten, Dr.
24248 Mönkeberg (DE)**
- **Hilkert, Gottfried, Dr.
55291 Saulheim (DE)**
- **Hora, Franz
65830 Kriftel (DE)**

(74) Vertreter: **Schweitzer, Klaus, Dr. et al
Patentanwaltskanzlei Zounek,
Industriepark Kalle-Albert,
Gebäude H391
Rheingaustrasse 190-196
65174 Wiesbaden (DE)**

(54) **Orientierte, mittels elektromagnetischer Strahlung strukturierbare Folie aus thermoplastischem Polyester, Verfahren zu ihrer Herstellung und ihre Verwendung**

(57) Die Erfindung betrifft eine ein- oder mehrschichtige, orientierte Folie aus einem Polyester, der ein Additiv enthält, welches unter Bestrahlung mit elektromagnetischer Strahlung Metallkeime bildet, an denen sich in weiteren Prozessschritten weiteres Metall anlagern lässt. Die Folie enthält weiterhin ein weiteres, Strahlung absorbierendes Material. Die Erfindung betrifft ferner ein Verfahren zur Herstellung dieser Folie und ihre Verwendung in Leiterplatten, Flachbandkabeln, Smartcards, RFID-Labels, Folientastaturen und folienbasierten Schaltungen aller Art.

EP 1 559 740 A1

## Beschreibung

Die Erfindung betrifft eine ein- oder mehrschichtige, orientierte Folie aus einem Polyester, der ein Additiv enthält, welches unter Bestrahlung mit elektromagnetischer Strahlung Metallkeime bildet, an denen sich in weiteren Prozessschritten weiteres Metall anlagern lässt. Die Folie enthält weiterhin ein weiteres, Strahlung absorbierendes Material. Die Erfindung betrifft ferner ein Verfahren zur Herstellung dieser Folie und ihre Verwendung in Leiterplatten, Flachbandkabeln, Smartcards, RFID-Labels, Folientastaturen und folienbasierten Schaltungen aller Art.

Die Verwendung von Polyesterfolien für Elektroisolieranwendungen ist Stand der Technik. Die immer höheren Anforderungen hinsichtlich Komplexität der Schaltungen auf kleinem Raum sowie die Notwendigkeit, solche Schaltungen schnell, flexibel und kostengünstig produzieren zu können, stellt hohe technologische Anforderungen an die Folie und die Weiterverarbeitungsschritte.

Konventionelle Verfahren zur Herstellung flexibler Schaltungen betreffen meist die vollflächige Metallisierung der Folienbahn oder Kaschierung der Folienbahn mit Metallfolie und anschließendes Strukturieren der so entstandenen leitfähigen Flächen mit verschiedenen Verfahren, z. B. Ätzen oder mechanisches Entfernen der unerwünschten Metallmengen. Bei weiteren Verfahren wird das Metall aufgeprägt/aufgedruckt, beziehungsweise es wird eine Leitpaste aus Kohle/Silber aufgetragen. Nachteile dieser Verfahren liegen in der geringen Flexibilität und Präzision solcher Verfahren, welche einen größeren Abstand der Leiterbahnen untereinander bedingt und/oder der hohen mit diesen Verfahren verbundenen Kosten und/oder der niedrigen Produktionsgeschwindigkeiten.

In der EP-A-1 274 288 wird ein Verfahren beschrieben, bei dem aus kupferhaltigen Metalloxiden durch Laserbestrahlung Kupferkeime gebildet werden, an denen in einem anschließenden Galvanisierungsschritt weiteres Kupfer abgeschieden wird. In dieser Druckschrift werden ausschließlich Spritzgussteile beschrieben, und es fehlen Hinweise, wie und ob das Verfahren für Polyesterfolien und Folien im Allgemeinen angewendet werden kann. Insbesondere fehlen Hinweise, wie die Rohstoffe und Additive beschaffen sein müssen, um daraus orientierte Folien herstellen zu können. Das in EP-A-1 274 288 beschriebene PBT / $SiO_2$ / Spinell Compound ist zur Herstellung orientierter Folien ungeeignet, da das verwendete Polybutylenterephthalat aufgrund seiner hohen Kristallisationsgeschwindigkeit und dem hohen Füllgrad mit pyrogener Kieselsäure nicht verfahrenssicher verarbeitbar ist.

Insbesondere fehlen Hinweise, wie eine Folie mit hinreichender Dimensionsstabilität bei lokaler Erwärmung nach Bestrahlung mit elektromagnetischer Strahlung und Weiterverarbeitung hergestellt werden kann.

Bei Folien besteht aufgrund der geringen Schichtdicke zudem das Problem, dass die Absorption von Strahlung zu gering ist und somit die absorbierte Energie unter Umständen zu gering sein kann, um die Umwandlung der Metallsalze in die elementaren Metalle auszulösen. Daher müssen die aktivierbaren Metallverbindungen in sehr hoher Konzentration zugegeben werden, was bei Schwermetallverbindungen wie Kupferverbindungen aufgrund von Umweltschutzaspekten nicht wünschenswert ist.

Aufgabe der vorliegenden Erfindung ist es, eine Folie bereitzustellen, welche die genannten Nachteile nicht aufweist und die eine strahlungsaktivierbare Verbindung enthält, die Metallkeime bildet, an denen sich in weiteren Verfahrensschritten weiteres Metall anlagern lässt. Weiterhin soll eine solche Folie neben einer wirtschaftlichen Herstellung und einer guten Verstreckbarkeit, gute mechanische Eigenschaften, das bedeutet einen hohen E-Modul in Längs- und Querrichtung, sowie einen definierten Schrumpf aufweisen.

Gelöst wird diese Aufgabe durch eine ein- oder mehrschichtige, mindestens uniaxial gestreckte thermoplastische Polyesterfolie mit einer Dicke von 5 bis 500 µm, die

a) 0,5 bis 15 Gew.% einer durch elektromagnetische Strahlung aktivierbaren Metallverbindung und
b) ein Strahlung absorbierendes Material in einer Menge von 0,1 bis 15 Gew.-%, jeweils bezogen auf die Folie, enthält.

Die Folie besitzt eine Stärke vorzugsweise von 12 bis 200 µm und insbesondere von 30 bis 150 µm und enthält vorzugsweise 1,5 bis 10 Gew.% und insbesondere 2 bis 8 Gew.% der Komponente a) und vorzugsweise 0,5 bis 5 Gew-% und insbesondere 0,8 bis 2 Gew-% der Komponente b).

Unter einer strahlungsaktivierbaren Verbindung a) ist eine metallhaltige (anorganische oder organische) Verbindung zu verstehen, die infolge einer Absorption von elektromagnetischer Strahlung in einer chemischen Reaktion Metall in elementarer Form freisetzt. Diese chemische Reaktion kann auch unter Beteiligung weiterer Reaktionspartner erfolgen. Weiterhin ist es möglich, dass die elektromagnetische Strahlung nicht direkt von der metallhaltigen Verbindung absorbiert wird, sondern durch andere Substanzen, die anschließend die absorbierte Energie auf die metallhaltige Verbindung übertragen und so die Freisetzung von elementarem Metall bewirken. Bei der elektromagnetischen Strahlung kann es sich um UV-Licht (Wellenlänge 100 bis 400 nm), sichtbares Licht (Wellenlänge 400 bis 800 nm) oder Infrarotlicht (Wellenlänge 800 bis 25.000 nm) handeln. Weitere bevorzugte Strahlungsformen sind Röntgen-, Gamma- und Partikelstrahlung (Elektronen-, $\alpha$- und $\beta$-Strahlung).

Die Anlagerung von weiterem Metall an die durch elektromagnetische Strahlung erzeugten Metallkeime erfolgt

bevorzugt durch galvanische (nasschemische) Verfahren.

Zu einer guten Verstreckbarkeit zählt, dass sich die Folie bei ihrer Herstellung hervorragend uniaxial oder biaxial ohne Abrisse orientieren lässt.

Zu den guten mechanischen Eigenschaften zählen unter anderem ein hoher E-Modul in mindestens einer Folienrichtung (Längsrichtung (MD) und/oder Querrichtung (TD)) von größer/gleich (≥) 500 $N/mm^2$, bevorzugt größer/gleich (≥) 2000 $N/mm^2$ und besonders bevorzugt größer/gleich (≥) 4000 $N/mm^2$.

In einer bevorzugten Ausführungsform weist die Folie gemäß der Erfindung in keiner Folienrichtung (weder in MD noch in TD) einen Schrumpf von größer 25 % bei 200 °C auf. Vorzugsweise ist der Schrumpf bei 200 °C kleiner/gleich (≤) 15 %, insbesondere kleiner/gleich (≤) 5 %.

Die erfindungsgemäße Folie enthält als Hauptpolymerbestandteil (d.h. zu 55 bis 100 Gew.-%, bevorzugt 70 bis 100 Gew.-% und besonders bevorzugt 90 bis 100 Gew.-%) einen thermoplastischen Polyester.

Erfindungsgemäß versteht man unter einem thermoplastischen Polyester

- Homopolyester,
- Copolyester,
- Blends verschiedener Polyester,

wobei diese sowohl als reine Rohstoffe, als auch als Rezyklat enthaltende Polyesterrohstoffe eingesetzt werden können.

Polyester enthalten Wiederholungseinheiten, die sich von Dicarbonsäuren (100 Mol-%) und Diolen (ebenfalls 100 Mol-%) ableiten. Die erfindungsgemäßen Polyester basieren bevorzugt auf Terephthalsäure oder 2,6-Naphthalindicarbonsäure als Dicarbonsäure und auf Ethylenglykol oder 1,4-Butandiol als Diol (PET, PBT und PEN).

Insbesondere enthalten die erfindungsgemäßen Polyester 10 bis 100 Mol-% Terephthalat oder 10 bis 100 Mol-% 2,6-Naphthalat als Dicarbonsäurekomponenten, wobei die Gesamtmenge an Dicarbonsäurekomponenten 100 Mol-% ausmacht. Als weitere Dicarbonsäurekomponenten kann der erfindungsgemäße Polyester 0 bis 50 Mol-% 2,6-Naphthalat (wenn als Hauptkomponente Terephthalat eingesetzt wurde), 0 bis 50 Mol-% Terephthalat (wenn als Hauptkomponente Naphthalat verwendet wurde), 0 bis 20 Mol-% Isophthalat (bevorzugt 0,5 bis 4 Mol-%) sowie 10 bis 60 Mol-% 4,4'-Diphenyldicarboxylat enthalten. Andere Dicarbonsäurekomponenten wie 1,5-Naphthalindicarboxylat sollen gegebenenfalls einen Anteil von 30 Mol-%, bevorzugt 10 Mol-%, insbesondere 2 Mol-%, nicht überschreiten.

Als Diolkomponente enthält der erfindungsgemäße Polyester im allgemeinen 10 bis 100 Mol-% Ethylenglykol (EG), wobei die Gesamtmenge an Diolkomponenten 100 Mol-% ausmacht. Werden Mischungen verschiedener Diole eingesetzt, ist es vorteilhaft, den Anteil an Diethylenglykol mit 10 Mol-% nicht zu überschreiten und vorzugsweise 0,5 bis 5 Mol-% einzusetzen. Andere Diolkomponenten wie Cyclohexandimethanol, 1,3-Propandiol, 1,4-Butandiol sollen zweckmäßigerweise einen Anteil von 50 Mol-% nicht überschreiten und liegen bevorzugt bei einem Anteil von weniger als 30 Mol-%, besonders bevorzugt bei weniger als 10 Mol-%.

Neben den genannten Hauptpolymerbestandteilen kann die Folie in weiteren Ausführungsformen bis zu 45 Gew.-%, bevorzugt bis zu 30 Gew.-%, besonders bevorzugt bis zu 20 Gew.-%, bezogen auf die Masse der Folie, andere Polymere wie Polyetherimide (z.B. Ultem® 1000 von GE Plastics Europe/ NL), Polycarbonat (z.B. Makrolon® von Bayer/ DE), Polyolefine wie COC's (z.B. Topas® von Ticona/DE), Polyamide (Ultramid® von BASF/ DE) u.a. enthalten.

Die angeführten Polyester können auch als Mischungen eingesetzt werden.

Allgemein werden die Polyester nach literaturbekannten Verfahren aus den genannten Diolen und Dicarbonsäure oder Dicarbonsäureester hergestellt. Die Herstellung der Polyester kann sowohl nach dem Umesterungsverfahren mit den üblichen Katalysatoren wie Zn-, Ca-, Li- und Mn-Salzen oder nach dem Direktveresterungsverfahren erfolgen.

Die erfindungsgemäße Folie ist entweder ein- oder mehrschichtig. Die mehrschichtigen Folien sind mindestens zweischichtig und bestehen aus einer Basisschicht B, mindestens einer Deckschicht A oder C und gegebenenfalls weiteren Zwischenschichten, wobei insbesondere ein dreischichtiger A-B-A- oder A-B-C-Aufbau bevorzugt ist. Für diese Ausführungsform ist es vorteilhaft, wenn das Polymer der Basisschicht B eine ähnliche Schmelzeviskosität besitzt wie jene(s) der Deckschicht(en), die an die Basisschicht angrenzt (angrenzen).

Die Dicke der Deckschicht/en wird unabhängig von den anderen Schichten gewählt und liegt im Bereich von 0,1 bis 10 µm, vorzugsweise 0,2 bis 5 µm, insbesondere 1 bis 3 µm, wobei beidseitig aufgebrachte Deckschichten bezüglich Dicke und Zusammensetzung gleich oder verschieden sein können. Die Dicke der Basisschicht ergibt sich entsprechend aus der Differenz von Gesamtdicke der Folie und der Dicke der aufgebrachten Deck- und Zwischenschicht/en und kann daher analog der Gesamtdicke innerhalb weiter Grenzen variieren.

Die strahlungsaktivierbare Verbindung a) besteht aus elektrisch nichtleitenden, thermisch hochstabilen organischen oder anorganischen Metallverbindungen. Solche Verbindungen sind in EP-A-1 274 288 beschrieben. Bevorzugt sind hierbei Verbindungen von Metallen der d- und f- Gruppe des Periodischen Systems mit Nichtmetallen. Besonders bevorzugt handelt es sich bei den metallhaltigen Verbindungen um Metalloxide, insbesondere um Monoxide der d-Metalle des Periodischen Systems. Besonders geeignet sind höhere Metalloxide. Gemäß einer besonders bevorzugten Ausführungsform der Erfindung sind die höheren Oxide Spinelle, insbesondere kupferhaltige Spinelle wie $CuCr_2O_4$. Geeignete kupferhaltige Spinelle sind kommerziell erhältlich, so z.B. der Typ PK 3095 der Fa. Ferro/DE oder die Typen 34E23 oder 34E30 der Fa. Johnson Matthey/DE. Besonders geeignet sind weiterhin Kupferoxide der Formel CuO oder $Cu_2O$, wobei bevorzugt Nanopartikel eingesetzt werden wie NanoArc® Copper Oxide der Fa. Nanophase Technologies Corporation/Illinois,USA.

Die erfindungsgemäße Folie enthält diese Verbindungen in einer Konzentration von 0,5 bis 15 Gew.-%, bevorzugt 1,5 bis 10 Gew.-% und besonders bevorzugt 2 bis 8 Gew.-%.

Sofern die metallhaltige Verbindung a) in dem zur Folienherstellung verwendeten Polyester nicht löslich ist, handelt es sich um Partikel mit einer mittleren Größe ($d_{50}$-Wert) von 0,01 bis 20 µm, bevorzugt 0,02 bis 5 µm und besonders bevorzugt 0,05 bis 3 µm.

Neben der strahlungsaktivierbaren Verbindung a) kann die erfindungsgemäße Folie weitere partikuläre Additive wie Füllstoffe und Antiblockmittel enthalten. Typische Füllstoffe und Antiblockmittel sind anorganische und/oder organische Partikel, beispielsweise Siliciumdioxid (natürlich, gefällt oder pyrogen), Calciumcarbonat, Magnesiumcarbonat, Bariumcarbonat, Calciumsulfat, Bariumsulfat, Lithiumphosphat, Calciumphosphat, Magnesiumphosphat, Titandioxid (Rutil oder Anatas), Kaolin (hydratisiert oder kalziniert), Aluminiumoxid, Aluminiumsilikat, Lithiumfluorid, Calcium-, Barium-, Zink- oder Mangansalze der eingesetzten Dicarbonsäuren oder vernetzte Polymerpartikel, z.B. Polystyrol oder Polymethylmethacrylatpartikel, vorzugsweise Siliciumdioxid.

Es können auch Mischungen von zwei oder mehreren der oben genannten Partikelsysteme oder Mischungen von Partikelsystemen mit gleicher chemischer Zusammensetzung, aber unterschiedlicher Partikelgröße gewählt werden. Die Partikel werden dem Polyester zweckmäßigerweise schon vor dem Aufschmelzen zugesetzt.

Sofern neben der strahlungsaktivierbaren Verbindung a) weitere partikuläre Additive in der Folie enthalten sind, beträgt die Gesamtkonzentration dieser Partikel weniger als 20 Gew.-%, bezogen auf das Gesamtgewicht der Folie, bevorzugt weniger als 15 Gew.-% und besonders bevorzugt weniger als 5 Gew.-%. Die partikulären Additive haben eine mittlere Größe ($d_{50}$-Wert) von 0,01 bis 15 µm, bevorzugt 0,03 bis 10 µm und besonders bevorzugt 0,05 bis 1 µm. In einer bevorzugten Ausführungsform liegt der Anteil von Partikeln mit einem $d_{50}$-Wert von größer/gleich (≥) 3 µm bei kleiner/gleich (≤) 2000 ppm und besonders bevorzugt bei kleiner/gleich (≤) 1000 ppm.

Es hat sich gezeigt, dass auch Folien ohne weitere partikuläre Additive (außer der strahlungsaktivierbaren Metallkomponente) gemäß der Erfindung eingesetzt werden können. Die Bildung der Metallkeime wird jedoch verbessert, wenn die Folie als Füllstoff Siliziumdioxid in den oben genannten Maximalmengen und Teilchengrößen enthält. Für die Bildung der Metallkeime hat es sich als besonders günstig erwiesen, wenn die Folie 0,1 bis 20 Gew.-% bevorzugt 0,5 bis 15 Gew.-% und besonders bevorzugt 1 bis 5 Gew.-% Siliciumdioxid-Partikel mit einem $d_{50}$-Wert von kleiner/gleich (≤)1 µm enthält.

Alternativ zum $SiO_2$ kann auch $Al_2O_3$ (z.B. AEROXIDE® Alu C der Fa. Degussa/DE) eingesetzt werden. Die Mengen und Partikelgrößen entsprechen denen, die im vorhergehenden Absatz für $SiO_2$ genannt wurden.

Die erfindungsgemäße Folie enthält weiterhin neben der strahlungsaktivierbaren Metallverbindung a) ein weiteres, Strahlung absorbierendes Material b) in einer Menge von 0,1 bis 15 Gew.-%, bevorzugt 0,5 bis 5 Gew.-% und besonders bevorzugt 0,8 bis 2 Gew.-%, bezogen auf die Folie. Dieses Material absorbiert bevorzugt im Wellenlängenbereich der zur Metallkeimbildung verwendeten Strahlenquelle.

Bevorzugte Materialien sind dabei Graphit oder Ruß oder anorganische und organische Schwarzpigmente wie Pigment Black26 (z.B. $Fe_2O_3/MnO_2/SiO_2/Al_2O_3$ der Fa. Anirox Pigments Limited / IN) oder Anilinschwarz der Fa. Degussa/DE. Bei Rußen und Graphiten ist es vorteilhaft, Typen mit geringer Leitfähigkeit wie Spezialschwarz 4 oder Aerospace15 der Fa. Degussa/DE zu verwenden.

Es ist zweckmäßig, dass sich die Komponenten a) und b) jeweils gemeinsam in mindestens einer der Schichten der Folie befinden. Möglich ist aber auch ein getrennter Einsatz in verschiedenen Schichten. Es ist jedoch darauf zu achten, dass sich die Mengenangaben der verwendeten Komponenten in den angeführten Grenzen halten.

Die erfindungsgemäße Folie kann weitere Additive wie UV-Stabilisatoren, Flammschutzmittel, Hydrolysestabilisatoren und Antioxidantien enthalten, wobei insbesondere UV-Stabilisatoren wie Tinuvin® der Fa. Ciba/CH ebenfalls zu einer verbesserten Metallkeimbildung beitragen, wenn eine UV-Strahlenquelle verwendet wird, da sie die eingestrahlte UV-Energie effektiv absorbieren.

In einer weiteren Ausführungsform ist die erfindungsgemäße Folie flammhemmend ausgerüstet. Flammhemmend bedeutet, dass die Folie in einer sogenannten Brandschutzprüfung gemäß UL94 VTM mindestens die Klasse VTM-2 erreicht. Die Folie enthält dann ein Flammschutzmittel in einer Konzentration im Bereich von 0,2 bis 30 Gew.-%, bevorzugt 0,5 bis 25 Gew.-%, besonders bevorzugt von 1,0 bis 20 Gew.-%, bezogen auf das Gewicht der Folie. Wesentlich ist, dass das Flammschutzmittel im Polyester löslich ist, da andernfalls die geforderten mechanischen Eigenschaften nicht erreicht werden. Geeignete Flammschutzmittel sind beispielsweise organische Brom-, Chlor- oder Stickstoffverbindungen oder Metallhydroxide oder -trihydrate. Die Halogenverbindungen haben allerdings den Nachteil, dass im Brandfall toxische und korrosiv wirkende Halogenwasserstoffe entstehen. Nachteilig ist auch die geringe Lichtbeständigkeit einer damit ausgerüsteten Folie. Weitere geeignete Flammschutzmittel sind beispielsweise organische Phosphorverbindungen wie Carboxyphosphinsäuren, deren Anhydride und Methanphosphonsäuredimethylester. Sehr geeignet sind hierbei Flammschutzmittel, bei denen die Phosphorverbindung chemisch an den Polyester gebunden ist. Ganz besonders bevorzugt ist [(6-oxido-6H-dibenz[c,e][1,2]oxaphosphorin-6-yl)methyl]butandicarbonsäure-bis-(2-hydroxyethyl)ester mit der Formel

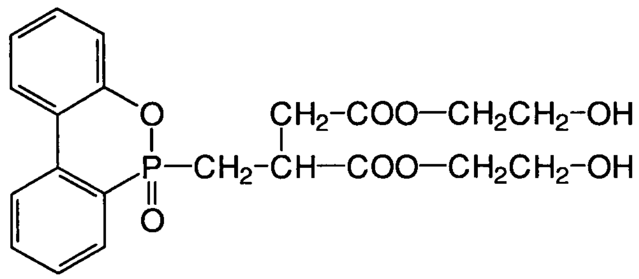

In dieser bevorzugten Ausführungsform enthält die erfindungsgemäße, schwer entflammbare Folie neben dem Polyester, der strahlungsaktivierbaren Verbindung und gegebenenfalls partikulären Additiven, 1 bis 20 Gew.-% einer im Polyester löslichen organischen Phosphorverbindung als Flammschutzmittel.

Da die Flammschutzmittel im allgemeinen eine gewisse Hydrolyseempfindlichkeit aufweisen, kann der zusätzliche Einsatz eines Hydrolysestabilisators sinnvoll sein. Geeignete Hydrolysestabilisatoren sind beispielsweise polymere Carbodiimide wie z.B. Stabaxol P® der Fa. Rheinchemie/DE. Diese werden bevorzugt in einer Menge von 0,1 bis 1 Gew.-%, bezogen auf die Masse der Folie, eingesetzt.

Diese oben genannten Anteile an Flammschutzmittel und Hydrolysestabilisator haben sich auch dann als günstig erwiesen, wenn der Hauptbestandteil der Folie nicht Polyethylenterephthalat, sondern ein anderer Polyester ist.

Die strahlungsaktivierbare Verbindung a) sowie die strahlenabsorbierende Verbindung b) und die gegebenenfalls verwendeten weiteren Additive wie Partikel, UV-Stabilisatoren, Flammschutzmittel, Hydrolysestabilisatoren und Antioxidantien können dem zur Herstellung der erfindungsgemäßen Folie verwendeten Polyester als glykolische Dispersion während der Polykondensation zugegeben werden. Bevorzugt ist jedoch die Zugabe der strahlungsaktivierbaren Komponente und/oder der gegebenenfalls verwendeten weiteren Additive über Masterbatche zum Polyesterrohstoff während der Folienextrusion.

Ebenso kann die Folie zur Einstellung weiterer Eigenschaften beschichtet werden. Typische Beschichtungen sind insbesondere haftvermittelnd, antistatisch, schlupfverbessernd oder dehäsiv wirkende Schichten. Es bietet sich an, diese zusätzlichen Schichten über in-line coating mittels wässriger Dispersionen nach der Längs- und vor der Querstreckung auf die Folie aufzubringen.

In einer besonderen Ausführungsform weist die Folie mindestens einseitig eine Silikonbeschichtung auf, wie sie z.B. in der US-A-57 28 339 beschrieben ist. Diese Ausführungsform hat den Vorteil, dass nach der Laserbehandlung die umliegenden Bereiche vor der korrodierenden Wirkung des galvanischen Bades geschützt sind und sich Reste der Galvaniklösung leichter von der Folienoberfläche entfernen lassen.

Für bestimmte Anwendungen kann es zweckmäßig sein, die Oberfläche der Folie mit einer Säure chemisch vorzubehandeln. Für diese sogenannte Ätzhaftvermittlung eignen sich insbesondere Trichloressigsäure, Dichloressigsäure oder Flusssäure, die für eine kurze Zeit (zwischen 5 und 120 sec) auf die Oberfläche einwirken und dann mittels Luftmesser wieder entfernt werden. Dadurch erhält die Folie eine sehr reaktive, amorphe Oberfläche.

Die Additive, also die strahlungsaktivierbare Metallverbindung a) und die Komponente b) sowie die gegebenenfalls vorhandenen weiteren Füllstoffe und sonstigen Additive, können mittels eines handelsüblichen Zweischneckenextruders in das Polymer eingebracht werden. Dabei wird ein Polyester gemäß der Erfindung in Granulatform zusammen mit den Partikeln/Additiven in den Extruder eingebracht und extrudiert, anschließend in einem Wasserbad abgeschreckt und dann granuliert.

In einem bevorzugten Verfahren zur Herstellung der erfindungsgemäßen Polyester werden die Additive aber direkt bei der Polyesterherstellung zugegeben. Üblicherweise werden die Additive im Falle des DMT-Verfahrens nach der Umesterung bzw. direkt vor der Polykondensation (z.B. über die Transportleitung zwischen Umesterungs- und Polykondensationskessel) als glykolische Dispersion zugegeben. Die Zugabe kann aber auch schon vor der Umesterung erfolgen. Im Falle des TPA-Verfahrens erfolgt die Zugabe bevorzugt zu Beginn der Polykondensation. Eine spätere Zugabe ist jedoch auch möglich. Es hat sich bei diesem Verfahren als günstig erwiesen, wenn die glykolischen Dispersionen vor der Zugabe über einen PROGAF PGF 57® (Hayward/Indiana, USA) Filter filtriert werden.

Gegenstand der vorliegenden Erfindung ist auch ein Verfahren zur Herstellung der Folie. Allgemein erfolgt die Herstellung durch ein Extrusionsverfahren, beispielsweise auf einer Extrusionsstrasse. Als besonders vorteilhaft hat es sich erwiesen, die strahlungsaktivierbare Komponente a) und das Strahlung absorbierende Material b) sowie die gegebenenfalls verwendeten weiteren Additive wie Partikel, UV-Stabilisatoren, Flammschutzmittel, Hydrolysestabilisatoren und Antioxidantien in den genannten Mengen in Form von vorgetrockneten oder vorkristallisierten Masterbatchen vor der Extrusion zuzugeben.

Bevorzugt bei der Masterbatchtechnologie ist, dass die Korngröße und das Schüttgewicht der Masterbatche ähnlich der Korngröße und dem Schüttgewicht des verwendeten Polyesterrohstoffs ist, so dass eine homogene Verteilung erreicht wird, aus der homogene Eigenschaften resultieren.

Die Polyesterfolien können nach bekannten Verfahren aus einem Polyesterrohstoff und gegebenenfalls weiteren Rohstoffen, mindestens einer strahlungsaktivierbaren Komponente sowie gegebenenfalls weiteren Additiven als ein- oder mehrschichtige Folie hergestellt werden.

Masterbatche, die die strahlungsaktivierbare Komponente enthalten, sind bevorzugt vorkristallisiert und/oder vorgetrocknet. Das gleiche gilt für Masterbatche, die die Strahlen absorbierende Komponente oder Partikel, UV-Stabilisator(en), Flammschutzmittel und/oder andere Additive enthalten. Die Vortrocknung beinhaltet ein graduelles Erhitzen der Masterbatche unter reduziertem Druck (20 bis 80 mbar, vorzugsweise 30 bis 60 mbar, insbesondere 40 bis 50 mbar) sowie Rühren und gegebenenfalls ein Nachtrocknen bei konstanter, erhöhter Temperatur (ebenfalls unter reduziertem Druck). Die Masterbatche werden vorzugsweise bei Raumtemperatur aus einem Dosierbehälter in der gewünschten Abmischung zusammen mit dem Polyesterrohstoff und gegebenenfalls anderen Rohstoffkomponenten chargenweise in einen Vakuumtrockner, der im Laufe der Trocken- bzw. Verweilzeit ein Temperaturspektrum von 10 bis 160 °C, vorzugsweise 20 bis 150 °C, insbesondere 30 bis 130 °C durchläuft, gefüllt. Während der etwa 6-stündigen, vorzugsweise 5-stündigen, insbesondere 4-stündigen, Verweilzeit wird die Rohstoffmischung mit 10 bis 70 Upm, vorzugsweise 15 bis 65 Upm, insbesondere 20 bis 60 Upm, gerührt. Das so vorkristallisierte bzw. vorgetrocknete Rohstoffgemisch wird in einem nachgeschalteten, ebenfalls evakuierten Behälter bei 90 bis 180 °C, vorzugsweise 100 bis 170 °C, insbesondere 110 bis 160 °C, für 2 bis 8 Stunden, vorzugsweise 3 bis 7 Stunden, insbesondere 4 bis 6 Stunden, nachgetrocknet.

Die Masterbatche sowie die übrigen Rohstoffe können aber auch bei Verwendung von Zwei- und Mehrschneckenextrudern ohne Vortrocknung direkt extrudiert werden.

Bei dem bevorzugten Koextrusionsverfahren zur Herstellung der Folie werden die den einzelnen Schichten der Folie entsprechenden Schmelzen durch eine Flachdüse koextrudiert und als weitgehend amorphe Vorfolie auf einer Kühlwalze abgeschreckt. Bei der erfindungsgemäßen einschichtigen Folie wird nur eine Schmelze durch die Düse extrudiert. Diese Folie wird anschließend erneut erhitzt und in mindestens einer Richtung bzw. in Längs- und Querrichtung bzw. in Quer- und Längsrichtung bzw. in Längs-, in Quer- und nochmals und Längsrichtung und /oder Querrichtung verstreckt (orientiert). Die Folientemperaturen im Streckprozess liegen im allgemeinen 10 bis 60 °C über der Glasübergangstemperatur $T_g$ des verwendeten Polyesters, das Streckverhältnis der Längsstreckung liegt üblicherweise bei 2 bis 6, insbesondere bei 3 bis 4,5, das der Querstreckung bei 2 bis 5, insbesondere bei 3 bis 4,5, und das der gegebenenfalls durchgeführten zweiten Längs- und Querstreckung bei 1,1 bis 5. Die erste Längsstreckung kann auch gleichzeitig mit der Querstreckung (Simultanstreckung) durchgeführt werden. Es folgt die Thermofixierung der Folie bei Ofentemperaturen von 180 bis 260 °C, vorzugsweise von 220 bis 250 °C. Anschließend wird die Folie abgekühlt und gewickelt.

In einer bevorzugten Ausführungsform findet die Thermofixierung bei Temperaturen von 220 bis 250 °C statt und die Folie wird bei dieser Temperatur um mindestens 1 %, bevorzugt mindestens 2 %, in Querrichtung relaxiert.

In einer weiteren bevorzugten Ausführungsform findet die Thermofixierung bei 220 bis 250 °C statt und die Folie wird bei dieser Temperatur um mindestens 1 %, bevorzugt mindestens 2 %, in Querrichtung relaxiert und anschließend nochmals bei Temperaturen zwischen 180 und 150 °C in der Abkühlphase um wiederum mindestens 1 %, bevorzugt mindestens 2 %, in Querrichtung relaxiert.

In einer weiteren bevorzugten Ausführungsform wird die Folie mindestens um den Faktor 3 in MD und TD Richtung gestreckt, wobei die Streckung in einem Simultanrahmen stattfindet. Die Thermofixierung findet bei 220 bis 250 °C statt und die Folie wird bei dieser Temperatur um mindestens 1 % in Längs- und Querrichtung relaxiert.

Die erfindungsgemäßen ein- oder mehrschichtigen Folien weisen die geforderten guten mechanischen Eigenschaften auf. So beträgt der E-Modul in mindestens einer Folienrichtung [Längsrichtung (MD) und/oder Querrichtung (TD)] größer/gleich (≥) 500 $N/mm^2$, bevorzugt größer/gleich (≥) 2000 $N/mm^2$ und besonders bevorzugt größer/gleich (≥) 4000 $N/mm^2$.

Die erfindungsgemäße mehrschichtige Folie weist in keiner Folienrichtung (weder in MD noch in TD) einen Schrumpf bei 200 °C von größer 25 % auf. Der Schrumpf bei 200 °C ist sogar kleiner/gleich (≤) 15 % und bevorzugt kleiner/gleich (≤) 5 %.

Durch die Kombination ihrer Eigenschaften eignen sich die erfindungsgemäßen Folien für eine Vielzahl verschiedener Anwendungen, beispielsweise für Leiterplatten, Flachbandkabel, Smartcards, RFID-Labels, Folientastaturen und folienbasierte Schaltungen aller Art.

Die Messung der einzelnen Eigenschaften in den Beispielen erfolgt dabei gemäß den folgenden Normen bzw. Verfahren.

## Messmethoden

### Mechanische Eigenschaften

Der E-Modul, die Reißfestigkeit, Reißdehnung und der $F_5$-Wert werden in Längs- und Querrichtung nach ISO 527-1-2 mit Hilfe eines Zug-Dehnungsmesser (Typ 010 der Fa. Zwick/DE) gemessen.

### Schrumpf

Der thermische Schrumpf wird an quadratischen Folienmustern mit einer Kantenlänge von 10 cm bestimmt. Die Proben werden genau ausgemessen (Kantenlänge $L_0$), 15 Minuten bei 200 °C in einem Umlufttrockenschrank getempert, und anschließend bei Raumtemperatur genau ausgemessen (Kantenlänge L). Der Schrumpf ergibt sich aus der Gleichung

$$\text{Schrumpf [\%]} = 100 \cdot (L_0 - L) / L_0$$

### Messung des mittleren Durchmessers $d_{50}$

Die Bestimmung des mittleren Durchmessers $d_{50}$ wird mittels Laser auf einem Malvern Master Sizer nach der Standardmethode durchgeführt. Andere Messgeräte sind z.B. Horiba LA 500 oder Sympathec Helos, welche das gleiche Messprinzip verwenden. Die Proben werden dazu in eine Küvette mit Wasser gegeben und diese dann in das Messgerät gestellt. Der Messvorgang ist automatisch und beinhaltet auch die mathematische Bestimmung des $d_{50}$-Wertes.

Der $d_{50}$-Wert wird dabei definitionsgemäß aus der (relativen) Summenkurve der Partikelgrößenverteilung bestimmt: der Schnittpunkt des 50 %-Ordinatenwertes mit der Summenkurve liefert auf der Abszissenachse sofort den gewünschten $d_{50}$-Wert. Wie dies zu verstehen ist, wird in der Fig. 1 näher verdeutlicht.

### Folienherstellung

Polyester-Chips wurden gemäß den in den Beispielen angegebenen Verhältnissen gemischt und ohne Vortrocknung jeweils in Zweischneckenextrudern aufgeschmolzen. Die geschmolzenen Polymerstränge wurden in einer Koextrusionsdüse zusammengeführt und über eine Abzugswalze (Temperatur der Walze 20 °C) abgezogen. Der Film wurde um den Faktor 3,5 in Maschinenrichtung bei 116 °C (Folientemperatur im Streckspalt) gestreckt und in einem Rahmen bei 110 °C eine Querstreckung um den Faktor 3,2 durchgeführt. Anschließend wurde die Folie bei 229 °C thermofixiert und in Querrichtung um 1 % bei Temperaturen von 229 bis 200 °C und ein weiteres mal um 1 % bei Temperaturen zwischen 180 und 150 °C relaxiert. Die Produktionsgeschwindigkeit (Endfoliengeschwindigkeit) beträgt 300 m/min. Die Endfoliendicke beträgt 100 µm.

## Beispiele

In den Beispielen kommen die folgenden Rohstoffe zum Einsatz.

### Masterbatch MB1

15 Gew.-% PK3095 der Fa. Ferro und 85 Gew.-% Polyethylenterephthalat RT49 (PET) der Fa. Kosa/DE

### Masterbatch MB2

10 Gew.-% $Al_2O_3$ AEROXIDE® Alu C der Fa. Degussa/DE ($d_{50}$ der Agglomerate ca. 300 nm; Primärteilchen $d_{50}$ ca. 50 nm) und 90 Gew.-% Polyethylenterephthalat RT49 (PET)

**Masterbatch MB3**

15 Gew.-% CuO Nanopartikel NanoArc® Copper Oxide der Fa. Nanophase Technologies Corporation/Illinois, USA und 85 Gew.-% Polybutylenterephthalat (PBT)

**Masterbatch MB4**

15 Gew.-% Pigment Black26 ($Fe_2O_3$/$MnO_2$/$SiO_2$/$Al_2O_3$) der Fa. Anirox Pigments Limited/IN und 85 Gew.-% Polyethylenterephthalat RT49 (PET)

**Masterbatch MB5**

15 Gew.-% Spezialschwarz 4 der Fa. Degussa/DE und 85 Gew.-% Polyethylenterephthalat RT49 (PET)

**Rohstoff R1**

100 Gew.-% Polyethylenterephthalat RT49

**Rohstoff R2**

25 Gew.-% Aerosil® 90 der Fa. Degussa/DE, 5 Gew.-% PK3095 der Fa. Ferro und 70 Gew.-% Polybutylenterephthalat (PBT)

**Rohstoff R3**

100 Gew.-% Polybutylenterephthalat (PBT)

**Rohstoff R4**

100 Gew.-% Polyethylennaphthalat (PEN)

**Beispiel 1**

Es wurde eine ABC-Folie mit einer Dicke der Basisschicht von 94 µm und Deckschichten A und C mit je 3 µm, wie oben angegeben, hergestellt.
Rohstoffmischung Deckschicht A: 50 Gew.-% MB1; 10 Gew.-% MB2; 10 Gew.-% MB4; 30 Gew.-% R1
Rohstoffmischung Basisschicht B: 100 Gew.-% R1
Rohstoffmischung Deckschicht C: 20 Gew.-% MB2; 80 Gew.-% R1

**Beispiel 2**

Beispiel 1 wurde wiederholt. In die Basisschicht B wurde jedoch zusätzlich Rezyklat gegeben, welches aus der Folie aus Beispiel 1 hergestellt wurde.
Rohstoffmischung Basisschicht B: 50 Gew.-% R1; 50 Gew.-% Rezyklat

**Beispiel 3**

Beispiel 1 wurde wiederholt mit folgenden Änderungen:

Rohstoffmischung Deckschicht A: 50 Gew.-% MB3; 10 Gew.-% MB2; 10 Gew.-% MB5; 30 Gew.-% R1
Rohstoffmischung Basisschicht B: 100 Gew.-% R1
Rohstoffmischung Deckschicht C: 20 Gew.-% MB2; 80 Gew.-% R1

**Beispiel 4**

Beispiel 1 wurde wiederholt mit folgenden Änderungen:

Rohstoffmischung Deckschicht A: 50 Gew.-% MB1; 10 Gew.-% MB2; 10 Gew.-% MB5; 20 Gew.-% R1; 10 Gew.-

% R4
Rohstoffmischung Basisschicht B: 100 Gew.-% R1
Rohstoffmischung Deckschicht C: 20 Gew.-% MB2; 80 Gew.-% R1

**Beispiel 5**

Eine ABC-Folie wie in Beispiel 1 wurde aus folgenden Komponenten hergestellt:

Rohstoffmischung Deckschicht A: 50 Gew.-% MB1; 10 Gew.-% MB2; 10 Gew.-% MB5; 20 Gew.-% R1; 10 Gew.-% R4
Rohstoffmischung Basisschicht B und Deckschicht C = Rohstoffmischung Deckschicht A

Die Eigenschaften der Folien aus Beispielen 1 bis 5 können der Tabelle entnommen werden.

**Vergleichsbeispiel 1**

Es wurde versucht, wie oben angegeben, aus dem Rohstoff R2 (angelehnt an den Rohstoff aus dem Beispiel der EP-A-1 274 288) eine ABA-Folie mit einer Dicke der Basisschicht von 46 µm und Deckschichten A mit je 2 µm herzustellen.
Rohstoffmischung Deckschicht A: 100 Gew.-% R2
Rohstoffmischung Basisschicht B: 100 Gew.-% R2
Die Verstreckung der Folie erwies sich als unmöglich, da jeder Streckversuch zu Abrissen führte. Es konnte keine Folie hergestellt werden.

**Vergleichsbeispiel 2**

Rohstoffmischung Deckschicht A: 50 Gew.-% MB1; 10 Gew.-% MB2; 40 Gew.-% R1
Rohstoffmischung Basisschicht B: 100 Gew.-% R1
Rohstoffmischung Deckschicht C: 20 Gew.-% MB2; 80 Gew.-% R1

**Vergleichsbeispiel 3**

Beispiel 1 wurde wiederholt. Die Thermofixierung erfolgte jedoch nicht, wie oben angegeben, bei 229 °C, sondern bei 150 °C und es erfolgte keine Relaxation.
Die Eigenschaften der Folien der Vergleichsbeispiele 2 und 3 können der Tabelle entnommen werden.

**Leiterbahnerzeugung**

Die hergestellten Folien wurden im Bereich der aufzubringenden Leiterbahnen mit einem Laser (frequenzverdreifachten Nd:YAG-Laser ($\lambda$ = 355 nm) Lieferant Fa. LPKF AG/DE), mit einer Intensität bestrahlt, die einen geringfügigen Abtrag erzeugt, der mit einer strukturierten Bekeimung verbunden ist. Nach kurzer Behandlung in einem, demineralisiertes Wasser enthaltenden Ultraschall-Reinigungsbad wird die Folie durch ein handelsübliches chemisch reduktives Verkupferungsbad geführt. Hierdurch wurden in den bestrahlten Bereichen die Leiterbahnen aufgebaut. Abtrag 0,5 bis 1 µm.

**Ergebnisse der Leiterbahnerzeugung**

Die erzeugten Leiterbahnen wurden mittels eines Lichtmikroskops (Auflicht) bei 20facher Vergrößerung visuell beurteilt. Die Geschlossenheit der Kupferschicht wurde visuell bewertet und in die folgenden Kategorien eingeteilt: gut, weniger gut und schlecht.

Tabelle

| Beispiel | E-Modul MD in $N/mm^2$ | E-Modul TD in $N/mm^2$ | Schrumpf MD 200 °C | Schrumpf TD 200 °C | Leiterbahn-erzeugung |
|---|---|---|---|---|---|
| 1 | 4300 | 5400 | 4,9 | 1,8 | gut -sehr gut |
| 2 | 4400 | 5100 | 4,4 | 2,1 | gut - sehr gut |

Tabelle (fortgesetzt)

| Beispiel | E-Modul MD in $N/mm^2$ | E-Modul TD in $N/mm^2$ | Schrumpf MD 200 °C | Schrumpf TD 200 °C | Leiterbahn-erzeugung |
|---|---|---|---|---|---|
| 3 | 4200 | 5200 | 4,5 | 2 | gut - sehr gut |
| 4 | 4100 | 5300 | 4,2 | 1,9 | sehr gut |
| 5 | 3900 | 4700 | 4,1 | 1,5 | sehr gut |
| Vergleichs beispiel | | | | | |
| 1 | keine Folie erhalten | keine Folie erhalten | keine Folie erhalten | | keine Folie erhalten |
| 2 | 4100 | 5200 | 4,3 | 2,1 | mittel*) |
| 3 | 4700 | 5900 | 19 | 22 | mittel**) |

*) Bei gleicher Intensität und Bestrahldauer wie in den Beispielen 1 bis 5 war die Leiterbahnqualität deutlich schlechter bis unzureichend. Bei einer Erhöhung der Bestrahldauer konnten jedoch gute Werte für die Leiterbahnqualität erreicht werden.

**) Bei gleicher Intensität und Bestrahldauer wie in den Beispielen 1 bis 5 war die Leiterbahnqualität deutlich schlechter bis unzureichend. Bei einer Erhöhung der Bestrahldauer von Faktor 2 konnten jedoch gute Werte für die Leiterbahnqualität erreicht werden. Nach Laserbestrahlung bildeten sich jedoch Falten.

**Patentansprüche**

1. Ein- oder mehrschichtige, mindestens uniaxial gestreckte thermoplastische Polyesterfolie mit einer Dicke von 5 bis 500 µm, **dadurch gekennzeichnet, dass** sie

   a) 0,5 bis 15 Gew.-% einer durch elektromagnetische Strahlung aktivierbaren Metallverbindung und
   b) ein Strahlung absorbierendes Material in einer Menge von 0,1 bis 15 Gew.-%, jeweils bezogen auf die Folie, enthält.

2. Folie nach Anspruch 1, **dadurch gekennzeichnet, dass** die Folie eine Dicke vorzugsweise von 12 bis 200 µm und insbesondere von 30 bis 150 µm besitzt sowie vorzugsweise 1,5 bis 10 Gew.-% und insbesondere 2 bis 8 Gew.-% der Komponente a) und vorzugsweise 0,5 bis 5 Gew.-% und insbesondere 0,8 bis 2 Gew.-% der Komponente b), jeweils bezogen auf die Folie, enthält.

3. Folie nach Anspruch 1 oder 2, **dadurch gekennzeichnet, dass** der thermoplastische Polyester Polyethylenterephthalat, Polybutylenterephthalat, Polyethylennaphthalat oder eine Mischung daraus enthält.

4. Folie nach einem oder mehreren der Ansprüche 1 bis 3, **dadurch gekennzeichnet, dass** die strahlungsaktivierbare Metallverbindung a) eine elektrisch nichtleitende, thermisch hochstabile organische oder anorganische Verbindung, vorzugsweise ein Metalloxid oder ein Spinell ist.

5. Folie nach einem oder mehreren der Ansprüche 1 bis 4, **dadurch gekennzeichnet, dass** das strahlungsabsorbierende Material b) Graphit, Ruß oder anorganisches und organisches Schwarzpigment ist.

6. Folie nach einem oder mehreren der Ansprüche 1 bis 5, **dadurch gekennzeichnet, dass** sie weitere partikuläre Additive, vorzugsweise Siliciumdioxid, enthält.

7. Folie nach Anspruch 6, **dadurch gekennzeichnet, dass** die Folie 0,1 bis 20 Gew.-%, vorzugsweise 0,5 bis 15 Gew.-% und insbesondere 1 bis 5 Gew.-% Siliciumdioxid-Partikel mit einem $d_{50}$-Wert von kleiner/gleich 1 µm enthält.

8. Folie nach einem oder mehreren der Ansprüche 1 bis 7, **dadurch gekennzeichnet, dass** sie mindestens zweischichtig ist und mindestens aus einer Basisschicht und einer Deckschicht in Gegenwart oder Abwesenheit von weiteren Zwischenschichten besteht.

9. Folie nach Anspruch 8, **dadurch gekennzeichnet, dass** sie einen dreischichtigen Aufbau A-B-A oder A-B-C besitzt.

**10.** Folie nach einem oder mehreren der Ansprüche 1 bis 9, **dadurch gekennzeichnet, dass** die Dicke der Deckschichten im Bereich von 0,1 bis 10 µm, vorzugsweise 0,2 bis 5µm und insbesondere 1 bis 3 µm liegt und sich die Dicke der Basisschicht aus der Differenz von Gesamtdicke der Folie und der Dicke der aufgebrachten Deck- und Zwischenschicht(en) ergibt.

**11.** Folie nach einem oder mehreren der Ansprüche 1 bis 10, **dadurch gekennzeichnet, dass** sie einen E-Modul in mindestens einer Folienrichtung (Längsrichtung (MD) und/oder Querrichtung (TD)) von $\geq$ 500 N/mm$^2$ aufweist.

**12.** Folie nach einem oder mehreren der Ansprüche 1 bis 11, **dadurch gekennzeichnet, dass** sie ein Rezyklat als Rohstoff enthält.

**13.** Verfahren zur Herstellung einer ein- oder mehrschichtigen, mindestens uniaxial gestreckten thermoplastischen Polyesterfolie mit einer Dicke von 5 bis 500 µm, **dadurch gekennzeichnet, dass** man die den einzelnen Schichten der Folie entsprechenden Schmelzen, von denen mindestens eine Schicht eine durch elektromagnetische Strahlung aktivierbare Metallverbindung a) und ein Strahlung absorbierendes Material b) enthält, zusammen durch eine Schlitzdüse extrudiert, die erhaltene Folie abkühlt, erneut erhitzt und anschließend mindestens in einer Richtung orientiert und dann thermofixiert.

**14.** Verfahren nach Anspruch 13, **dadurch gekennzeichnet, dass** die Komponenten a) in einer Menge von 0,5 bis 15 Gew.-% und b) in einer Menge von 0,1 bis 15 Gew.-%, jeweils bezogen auf die Folie, zugesetzt werden und dass die Zugabe über die Masterbatchtechnologie erfolgt.

**15.** Verwendung der Folie nach einem oder mehreren der Ansprüche 1 bis 11 in Leiterplatten, Flachbandkabel, Smartcards, RFID-Labels, Folientastaturen und folienbasierten Schaltungen.

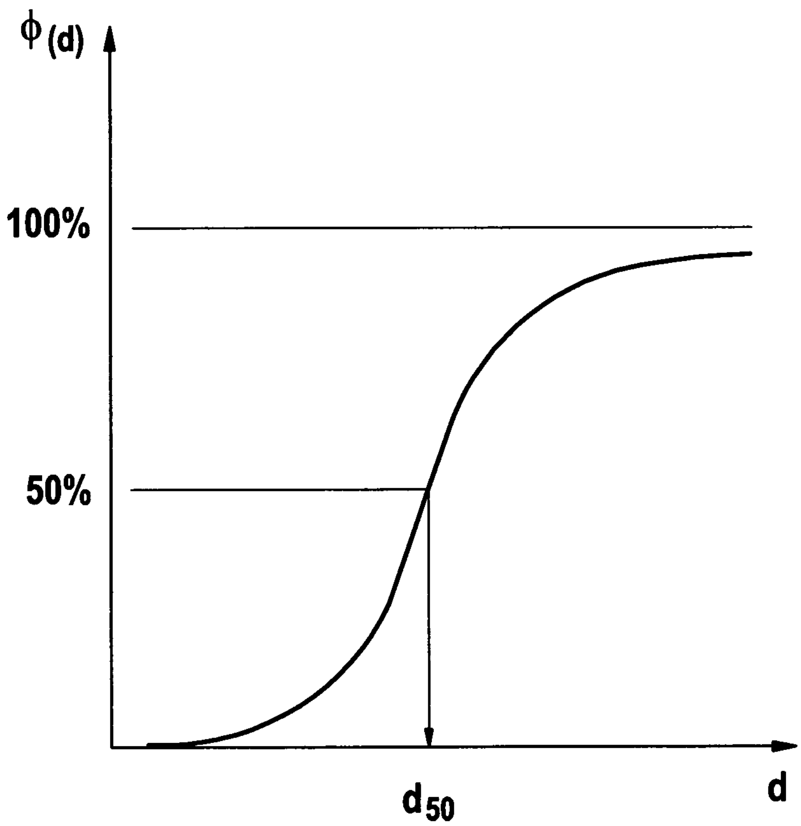
ϕ(d)
100%
50%
d50
d

Europäisches Patentamt

# EUROPÄISCHER RECHERCHENBERICHT

Nummer der Anmeldung
EP 05 00 0974

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 5 470 637 A (SAKAMOTO ET AL) 28. November 1995 (1995-11-28) * Spalte 4, Zeile 47 - Spalte 5, Zeile 5 * * Spalte 7, Zeilen 23-26; Anspruch 1 * | 1,5 | C08J5/18 C08L67/02 C08K3/00 C08K3/22 C23C18/16 H05K3/18 |
| A,D | EP 1 274 288 A (LPKF LASER & ELECTRONICS AG) 8. Januar 2003 (2003-01-08) * Absätze [0010], [0011], [0022]; Ansprüche 1-15 * | 1-15 | |
| A | WO 98/55669 A (NAUNDORF, GERHARD; WISSBROCK, HORST) 10. Dezember 1998 (1998-12-10) * Ansprüche 1-16 * | 1 | |

RECHERCHIERTE SACHGEBIETE (Int.Cl.7)
C08J
C08L
C08K
C23C
H05K

Der vorliegende Recherchenbericht wurde für alle Patentansprüche erstellt

| Recherchenort | Abschlußdatum der Recherche | Prüfer |
|---|---|---|
| München | 16. Februar 2005 | Hoffmann, K |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
&: Mitglied der gleichen Patentfamilie, übereinstimmendes Dokument

1

EPO FORM 1503 03.82 (P04C03)

**ANHANG ZUM EUROPÄISCHEN RECHERCHENBERICHT
ÜBER DIE EUROPÄISCHE PATENTANMELDUNG NR.** EP 05 00 0974

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

16-02-2005

| Im Recherchenbericht angeführtes Patentdokument | Datum der Veröffentlichung | Mitglied(er) der Patentfamilie | Datum der Veröffentlichung |
|---|---|---|---|
| US 5470637 A | 28-11-1995 | JP 5156140 A | 22-06-1993 |
| | | JP 5163371 A | 29-06-1993 |
| | | JP 3543972 B2 | 21-07-2004 |
| | | JP 5171012 A | 09-07-1993 |
| | | JP 3136718 B2 | 19-02-2001 |
| | | JP 5171017 A | 09-07-1993 |
| | | JP 5318579 A | 03-12-1993 |
| | | CA 2103557 A1 | 10-06-1993 |
| | | DE 69220932 D1 | 21-08-1997 |
| | | EP 0577838 A1 | 12-01-1994 |
| | | HK 1001591 A1 | 26-06-1998 |
| | | WO 9312177 A1 | 24-06-1993 |
| | | KR 255141 B1 | 01-05-2000 |
| EP 1274288 A | 08-01-2003 | DE 10132092 A1 | 23-01-2003 |
| | | WO 03005784 A2 | 16-01-2003 |
| | | EP 1274288 A1 | 08-01-2003 |
| | | JP 2004534408 T | 11-11-2004 |
| | | US 2004241422 A1 | 02-12-2004 |
| WO 9855669 A | 10-12-1998 | DE 19723734 A1 | 10-12-1998 |
| | | AT 231195 T | 15-02-2003 |
| | | CN 1272892 T | 08-11-2000 |
| | | DE 19731346 A1 | 04-03-1999 |
| | | DE 59806926 D1 | 20-02-2003 |
| | | WO 9855669 A2 | 10-12-1998 |
| | | EP 0917597 A2 | 26-05-1999 |
| | | JP 2000502407 T | 29-02-2000 |
| | | US 6319564 B1 | 20-11-2001 |

EPO FORM P0461

Für nähere Einzelheiten zu diesem Anhang : siehe Amtsblatt des Europäischen Patentamts, Nr.12/82